# NEUE EUROPÄISCHE PATENTSCHRIFT

(11) **EP 0 785 705 B2**
(45) Veröffentlichungstag und Bekanntmachung des Hinweises auf die Entscheidung über den Einspruch: **28.12.2016**
(45) Hinweis auf die Patenterteilung: 28.01.2004
(21) Anmeldenummer: 96118001.5
(22) Anmeldetag: 09.11.1996
(51) Int. Cl.: H05K 5/00, H05K 5/02, B60R 16/02

(54) **Gehäuse für eine elektrische Baugruppe**
Casing for an electrical equipment
Boîtier pour un équipement électrique

(30) Priorität: 17.01.1996 DE 19601518
(43) Veröffentlichungstag der Anmeldung: 23.07.1997
(73) Patentinhaber: WABCO GmbH, 30453 Hannover (DE)
(72) Erfinder: Krusel, William, Brighton, MI 48116 (US); Romer, Richard A., Rochester Hills, MI 48307 (US); Gröger, Jens, 30449 Hannover (DE); Risse, Rainer, 30982 Pattensen (DE); Kaess, Harald, 30916 Isernhagen N.B. (DE); Corcoran, Thomas, Troy, MI 48098 (US)

(56) Entgegenhaltungen:
- EP-A- 0 353 443
- WO-A-91/07865
- DE-A- 3 415 734
- DE-A- 4 102 265
- DE-A1- 2 554 747
- DE-A1- 3 937 190
- DE-A1- 3 937 191
- DE-A1- 3 937 192
- DE-A1- 4 102 265
- DE-A1- 4 221 137
- DE-C2- 4 210 979
- US-A- 3 900 769
- US-A- 5 006 960

## Beschreibung

Die Erfindung betrifft ein Gehäuse für eine elektrische Baugruppe gemäß dem Oberbegriff des Patentanspruchs 1.

Ein derartiges Gehäuse ist aus der DE 41 02 265 A1 bekannt.

Gehäuse dieser Art kommen an Einbauorten zum Einsatz, an denen sie mechanischen und elektromagnetischen Einflüssen und auch Witterungseinflüssen ausgesetzt sind. Von einem Gehäuse erwartet man, daß es die in ihr befindliche elektrische Baugruppe sicher vor derartigen Störeinflüssen schützt. Wenn ein derartiges Gehäuses z.B. an einer Kraftfahrzeugkarosserie oder im Motorraum eines Kraftfahrzeuges angeordnet ist, dann ist es von besonderer Wichtigkeit, daß das Gehäuse und die mit ihm verbundenen Teile, wie z.B. eine elektrische Steckverbindung, dicht sind und diese Eigenschaft auch dauerhaft beibehalten. Im praktischen Einsatz solcher Gehäuse und Steckverbindungen unter den zuvor beschriebenen Bedingungen tritt es jedoch sehr häufig auf, daß durch Lösen und Anstekken eines Steckverbinders oder durch eine Zugbelastung oder Abknikkung der elektrischen Anschlußkabel im Steckverbinder Undichtigkeiten auftreten.

Das bekannte Gehäuse erfüllt einen Teil dieser Forderungen und bietet außerdem noch die Möglichkeit, daß bei Einsatz eines Steckverbinders, dessen Kupplungsrichtung parallel zur flächigen Ausdehnung der Gehauseoberfläche verläuft, ein besonders kompakter Aufbau erzielt werden kann.

Beim bekannten Gehäuse ist es jedoch nachteilig, daß die aus dem Kupplungsteil der Steckverbindung austretenden elektrischen Anschlußkabel entweder gar nicht fixiert werden, oder daß diese Fixierung in einer größeren Entfernung vom Steckverbinder erfolgt. Die Verantwortung für die geeignete Auswahl des Fixierungspunktes liegt somit beim Anwender bzw. beim Installateur des elektrischen Gerätes. Wird dieser Fixierungspunkt ungünstig gewählt, kann es vorkommen, daß durch mechanische Belastungen der elektrischen Anschlußkabel, die auf das Kupplungsteil der Steckverbindung übertragen werden, wie z.B. Zugbelastung oder Vibrationen, die Dichtigkeit der Steckverbindung beeintrachtigt wird. Ein weiterer Nachteil ist, daß bei der hier genannten Art der Fixierung der elektrischen Anschlußkabel weitere Hilfsmittel wie ein Fixierungselement oder Montagewerkzeuge dafür erforderlich sind. Außerdem erfolgt die Montage des Fixierungselementes gesondert von der Montage des Gehäuses, was einen weiteren Arbeitsschritt bedeutet.

Der Erfindung liegt deshalb die Aufgabe zugrunde, ein Gehäuse für eine elektrische Baugruppe in platzsparender Ausführungsform anzugeben, durch das bei vereinfachter und kostengünstigerer Montage eine Fixierung der elektrischen Anschlußkabel derart ermöglicht wird, daß die Dichtigkeit der Steckverbindung dauerhaft gewährleistet wird.

Diese Aufgabe wird durch die im Patentanspruch 1 angegebene Erfindung gelöst. Weiterbildungen und vorteilhafte Ausgestaltungen der Erfindung sind in den Unteransprüchen angegeben.

Ein Vorteil der Erfindung besteht darin, daß die Fixierung der elektrischen Anschlußkabel durch Fixiermittel erfolgt, die wenigstens zum Teil einstückig mit dem Gehäuse ausgeführt sind, so daß einerseits bereits durch die Konstruktion des Gehäuses ein besonders geeigneter Fixierungspunkt festgelegt wird, und daß andererseits der Arbeits- und Kostenaufwand für die zur Zugentlastung der Anschlußkabel unbedingt notwendige Fixierung minimiert wird. Darüber hinaus wird der Anwender/Installateur des Gehäuses von der Auswahl eines geeigneten Befestigungspunktes befreit.

Dadurch, daß das Gehäuse so ausgebildet wird, daß es einen Bereich aufweist, in dem die elektrischen Anschlußkabel parallel zur flächigen Ausdehnung der Gehäuseoberfläche angeordnet und dort auch fixiert sind, wird in vorteilhafter Weise die mechanische Belastung der elektrischen Anschlußkabel sowie von dem ersten und zweiten elektrischen Anschlußelement auf ein Minimum reduziert. Es werden durch diese Art der Fixierung sowohl Zugkräfte als auch Biegekräfte, die bei ungeeigneter Wahl des Fixierungspunktes durch eine Querbewegung der elektrischen Anschlußkabel entstehen können, vermieden. Gehäuse, erstes und zweites elektrisches Anschlußelement, erstes Teil der Fixiermittel und ein Teil der elektrischen Anschlußkabel bilden nach der Montage eine kompakte Einheit, deren Elemente ihre Lage zueinander nicht mehr verändern können. Hierdurch ist das Gehäuse besonders zum Einsatz an solchen Einbauorten geeignet, an denen eine gute Dichtigkeit gefordert wird, wie z.B. im Motorraum oder an der Karosserie eines Kraftfahrzeuges.

Außerdem kann durch die einstückige Ausführung eines Teils der Fixiermittel mit dem Gehäuse der Herstellungsprozeß dieser beiden Elemente zu einem gemeinsamen Produktionsschritt zusammengefaßt werden.

Gemäß einer vorteilhaften Weiterbildung der Erfindung ist das Gehäuse so ausgebildet, daß mindestens eine Abdeckung für das erste und zweite elektrische Anschlußelement angebracht werden kann. Eine solche Abdeckung bietet den Vorteil, daß das erste und zweite elektrische Anschlußelement sowie ein Bereich der elektrischen Anschlußkabel vor Umwelteinflüssen wie z.B. Spritzwasser oder Steinschlag geschützt werden. In besonders vorteilhafter Weise kann diese Abdeckung mit einem zweiten Teil der Fixiermittel einstükkig ausgeführt sein, wobei die beiden Teile der Fixiermittel so ausgebildet sind, daß sie miteinander zur Anlage kommen können. Neben dem Vorteil einer weiteren Vereinfachung des Herstellungsprozesses bei einstükkiger Ausführung des zweiten Teils der Fixiermittel mit der Abdeckung bietet die beschriebene Weiterbildung außerdem den Vorteil, daß das zweite Teil der Fixiermittel das erste Teil der Fixiermittel in dessen vorteilhaften Auswirkungen noch unterstutzt.

Eine Vereinfachung bei der Fixierung der elektrischen Anschlußkabel durch die Fixermittel sowie bei der Montage der Abdeckung wird durch eine vorteilhafte Weiterbildung der Erfindung bewirkt, durch die die Fixierung der elektrischen Anschlußkabel allein durch das Schließen der Abdeckung bewirkt wird. Dies vereinfacht die Fixierung der elektrischen Anschlußkabel insofern, als daß bestimmte Montageschritte, die bei Fixiermitteln in Form von herkömmlichen Zugentlastungseinrichtungen erforderlich sind, wie z.B. das Anbringen einer Verschraubung, entfallen. Außerdem wird vermieden, daß Teile der Fixiermittel versehentlich falsch oder gar nicht montiert werden.

In einer besonders vorteilhaften Ausführungsform der Erfindung können das erste und das zweite Teil der Fixiermittel so ausgebildet sein, daß sie eine die elektrischen Anschlußkabel umgebende Hülle derart aufnehmen können, daß die Verbindung zwischen den Fixiermitteln und der Hülle formschlüssig erfolgt, z.B. durch Nuten in dem ersten und zweiten Teil der Fixiermittel und durch Verwendung eines Wellrohres, dessen äußere Form an die Nuten in den Fixiermitteln angepaßt ist, als Hulle. Dies vermeidet eine Krafteinwirkung auf die Anschlußkabel, die bei kraftschlüssig wirkenden Fixiermitteln, z.B. in Form einer Klemmung, auftreten könnte.

Gemäß einer weiteren Ausgestaltung weist das Gehäuse Befestigungselemente auf, mit denen die Abdeckung am Gehäuse befestigt werden kann. Vorzugsweise kommen als Befestigungselemente Scharniere zum Einsatz, die den Vorteil haben, daß die Abdeckung im geöffneten Zustand nicht verloren gehen kann und die Handhabung der Abdeckung beim Schließen vereinfacht wird, weil die exakte Positionierung am Gehäuse herstellerseitig bereits festgelegt ist.

Gemäß einer weiteren Weiterbildung ist das Gehäuse aus Metall gefertigt, wodurch es einerseits mechanisch sehr stabil ist, es aber andererseits auch die in ihm befindliche elektrische Baugruppe vor elektromagnetischen Störeinflüssen schützt. Durch diese Weiterbildung ist das Gehäuse außerdem besonders geeignet für den Einsatz in einem Kraftfahrzeug, z.B. als elektronisches Steuergerät. Die Abdeckung kann jedoch zur Minimierung der Herstellkosten aus Kunststoff gefertigt sein, weil die Anforderungen an die mechanische Festigkeit geringer sind als beim Gehäuse. Diese Materialauswahl ergibt außerdem bessere Recyclingmöglichkeiten als die Verwendung von Verbundwerkstoffen wie z.B. mit einer Metallschicht versehener Kunststoff als Gehäusematerial.

In einer Weiterbildung der Erfindung ist das erste elektrische Anschlußelement, das mit der elektrischen Baugruppe verbunden ist, als abgewinkelter Stecker ausgebildet. Dies bietet den Vorteil, daß die Steckkräfte nicht direkt auf die elektrische Baugruppe übertragen werden. Eine weitere Verbesserung kann erzielt werden, wenn das erste elektrische Anschlußelement mit langen Anschlußbeinen versehen ist, weil diese sowohl die verbleibenden Biegekräfte als auch im Betrieb des Gerätes auftretende thermische Verspannungen zwischen elektrischer Baugruppe und erstem elektrische Anschlußelement bestmöglich kompensieren. Durch die Anordnung der elektrischen Anschlußkabel parallel zur Gehäuseoberfläche ist eine geradlinige Verlegung der Anschlußkabel bis in das zweite elektrische Anschlußelement hinein möglich. Dies vereinfacht die Montage der Anschlußkabel im zweiten elektrischen Anschlußelement und führt außerdem zu einer besseren Abdichtung an der Übergangsstelle Anschlußkabel/ Anschlußelement, weil geradlinig verlegte Kabel keine Querkräfte auf eine z.B. innerhalb des zweiten elektrischen Anschlußelementes angeordnete Abdichtung übertragen.

In einer zweckmäßigen Weiterbildung der Erfindung besteht das Gehäuse aus mindestens zwei durch eine Teilungsebene voneinander getrennten Gehäuseteilen, wobei die Teilungsebene senkrecht zur elektrischen Baugruppe verläuft, so daß zur Montage der elektrische Baugruppe im Gehäuse die Gehäuseteile seitlich über die Leiterplatte gestülpt werden können. Im Vergleich zur parallel zur elektrischen Baugruppe verlaufenden Teilungsebene des bekannten Gehäuses bietet das erfindungsgemäße Gehäuse den Vorteil, aufgrund einer verkleinerten Teilungsfläche, die abzudichten ist, eine gute Dichtigkeit bereits mit verringertem Aufwand an Dicht- und Montagemitteln und somit auch eine verkürzte Montagedauer zu ermöglichen.

Gemäß einer Weiterbildung erfolgt die Fixierung des mit der elektrischen Baugruppe verbundenen ersten elektrischen Anschlußelementes an der Gehäusewand allein durch Pressung beim Zusammenfügen der Gehäuseteile, wobei hierdurch auch gleichzeitig eine Abdichtung zwischen Gehäuse und Steckverbinder durchgeführt wird.

Die Erfindung wird an Hand eines Ausführungsbeispiels unter Zuhilfenahme von Zeichnungen näher erläutert.

Es zeigen:
- Fig. 1: eine Draufsicht des Gehäuses mit einem Schnitt im oberen Bereich des Gehäuses (Schnitt B-B) und
- Fig. 2: eine Seitenansicht des Gehäuses mit einem Schnitt in Längsrichtung (Schnitt A-A) und
- Fig. 3: eine Vorderansicht des Gehauses mit einem Schnitt durch den vorderen Teil des Gehäuses sowie durch die Fixiermittel (Schnitt C-C).

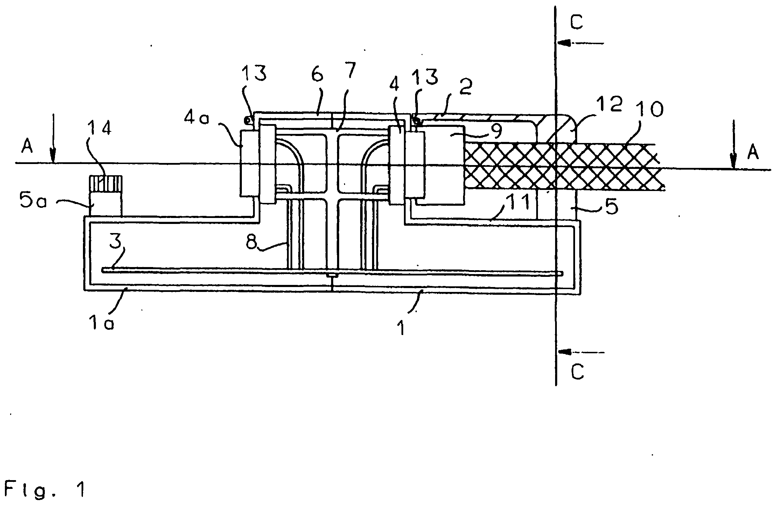

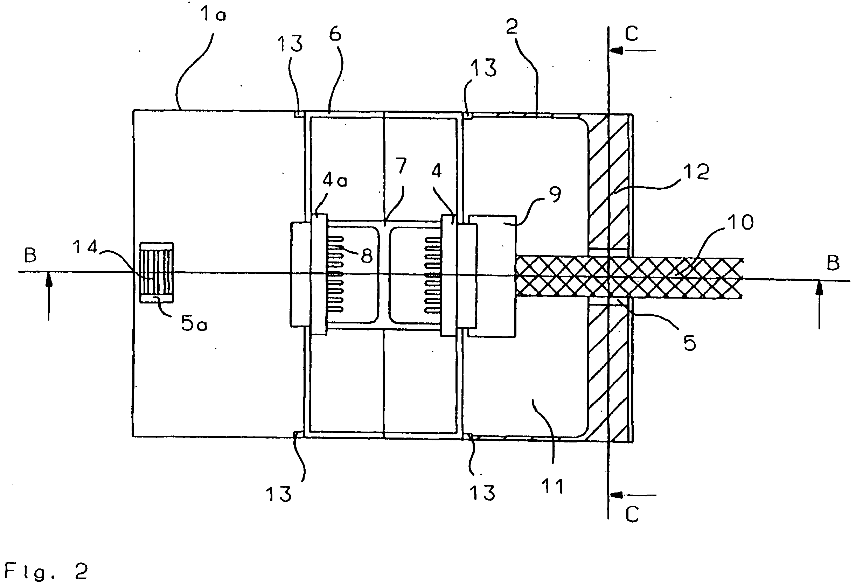

In den Fig. 1, 2 und 3 werden gleiche Bezugszeichen für einander entsprechende Teile verwendet. Zur übersichtlicheren Darstellung ist nur eines der beiden Gehäuseteile (1, 1a) mit dem zweiten elektrischen Anschlußelement (9), den elektrischen Anschlußkabeln (10) sowie der Abdeckung (2) gezeigt. Es sind jedoch beide Gehäuseteile (1, 1a) in gleicher Weise zur Aufnahme dieser Elemente geeignet.

Die in Fig. 1 dargestellte Ansicht zeigt ein Gehäuse, das aus zwei Gehäuseteilen (1, 1a) besteht, die miteinander verbunden sind. Als Mittel zur Verbindung der Gehäuseteile können z.B. Schrauben dienen, die hier jedoch nicht dargestellt sind. Im Gehäuseinneren ist eine elektrische Baugruppe (3) angeordnet, die z.B. als elektrische Leiterplatte ausgebildet sein kann. In einem sockelförmig abgestuften Teil (6) des Gehäuses ist in beiden Gehäuseteilen (1, 1a) jeweils ein erstes elektrisches Anschlußelement (4, 4a) angeordnet, das von innen an die Gehäusewand gepreßt wird.

Das erste elektrische Anschlußelement (4) ist mit einem ihm als Gegenstück zugeordneten zweiten elektrischen Anschlußelement (9) verbunden, das wiederum mit elektrischen Anschlußkabeln (10) versehen ist. Die elektrischen Anschlußkabel (10) sind parallel zu einem Bereich (11) des Gehäuses angeordnet. Ebenfalls im Bereich (11) des Gehäuses sind einstückig mit der Gehäuseoberfläche ausgeführte Fixiermittel (5, 5a) angeordnet, die die elektrischen Anschlußkabel (10) oder eine diese Anschlußkabel umgebende Hülle aufnehmen können. Die Fixierung der elektrischen Anschlußkabel kann z.B. mit einer Schelle, die auf die Fixiermittel (5, 5a) geschraubt wird, erfolgen.

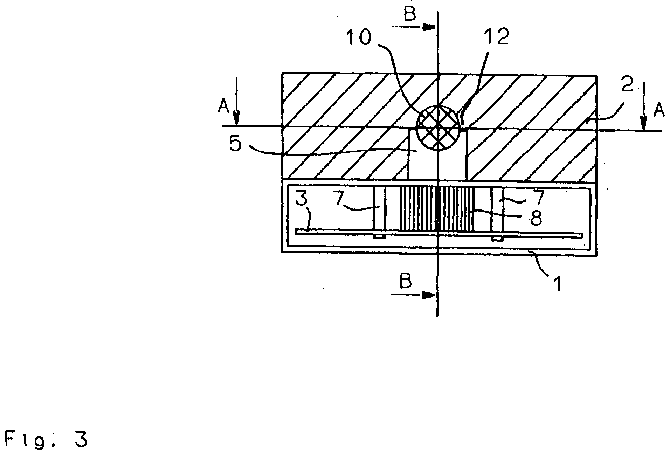

Vorteilhafter ist jedoch der Einsatz einer Abdeckung (2). Diese Abdeckung (2), die mit Scharnieren (13) am Gehäuseteil (1) angebracht ist, deckt die elektrischen Anschlußelemente (4, 9) sowie einen Teil der elektrischen Anschlußkabel (10) ab und weist außerdem ein zweites Teil (12) der Fixiermittel für die elektrischen Anschlußkabel (10) auf, das mit dem ersten Teil der Fixiermittel (5, 5a) zur Anlage kommen kann (s.a. Fig. 3). Hierdurch werden einerseits die sich im Inneren der Abdeckung (2) befindenden Elemente vor Umwelteinflüssen geschützt, andererseits ersetzt das einstükkig mit der Abdeckung (2) ausgeführte zweite Teil (12) der Fixiermittel die oben erwähnten weiteren Hilfsmittel (Schelle) zur Fixierung der elektrischen Anschlußkabel (10). Die Fixierung erfolgt dann allein durch das Schließen der Abdeckung (2). Im geschlossenen Zustand kann die Abdeckung (2) z.B. durch Schrauben oder eine Rastvorrichtung arretiert werden.

In einer Ausführungsform der Erfindung, bei der die elektrischen Anschlußkabel (10) in einer diese umgebenden Hulle geführt sind, wobei die Hülle in zweckmäßiger Weise als Wellrohr ausgebildet ist, können beide Teile der Fixiermittel (5, 5a und 12) bei den Fixiermitteln (5a) dargestellte Nuten (14) aufweisen, die geeignet sind, das Wellrohr formschlüssig aufzunehmen.

Als erstes elektrisches Anschlußelement (4, 4a) kann z.B. ein Stecker und als zweites elektrisches Anschlußelement (9) ein Kupplungsstück eingesetzt werden.

Die Stecker (4, 4a) werden durch weitere Fixiermittel (7) an der Gehäusewand gehalten. Die weiteren Fixiermittel, die sowohl einstückig mit den Steckern (4, 4a) als auch als separates Teil ausgeführt sein können, bewirken außerdem eine Entlastung der elektrischen Anschlußbeine (8) der Stecker (4, 4a) beim Aufstecken oder Abziehen des Kupplungsstückes (9). Die elektrischen Anschlußbeine (8) sowie die weiteren Fixiermittel (7) sind mit der elektrischen Leiterplatte (3) verbunden, z.B. durch Verlötung, Verrastung oder Verschraubung.

Aus der zuvor beschriebenen Art der Gehäuseausbildung ergeben sich Vorteile für die Herstellung und Montage der elektrischen Leiterplatte sowie des gesamten elektrischen Gerätes sowohl beim Hersteller als auch beim Anwender/Installateur.

Die Herstellung des elektrischen Gerätes kann z.B. wie folgend ablaufen: Die Leiterplatte (3) wird zunächst mit den weiteren Fixiermitteln (7) sowie den Steckern (4, 4a) und ggf. weiteren durch Verlöten zu befestigenden Bauteilen bestückt. Hiernach erfolgt die Verlötung, z.B. in einem Lötbad oder mittels einer Lötwelle. Bereits hiernach erfolgt die Prüfung der Funktion des elektrischen Gerätes, die dadurch sehr vereinfacht wird, daß einerseits die Kontaktierung von Prüfspitzen direkt auf der Leiterplatte (3) nicht durch Gehäuseteile erschwert wird, und daß andererseits die nun bereits mit der Leiterplatte (3) verbundenen Stecker (4, 4a) zum Anschluß von peripheren Komponenten oder Prufeinrichtungen mitbenutzt werden können. Zudem können auch die Stecker (4, 4a) auf einwandfreie Verlötung hin untersucht werden. Es kann somit bereits jetzt die gesamte Prüfung der elektrischen Funktion des Gerätes erfolgen, woraufhin nur noch die mechanische Montage im Gehäuse erfolgen muß.

Diese Montage erfolgt durch seitliches Überstülpen der beiden Gehäuseteile (1, 1a) über die zuvor beschriebene elektrische Baugruppe und durch Verschrauben der Gehäuseteile (1, 1a). Hierbei werden die Stecker (4, 4a) gegen das jeweilige Gehäuseteil (1 bzw. 1a) gepreßt. Eine weitere Befestigung der Stecker (4, 4a) an den Gehäuseteilen (1, 1a) z.B. durch Verschraubung ist nicht notwendig. Die Kräfte an den Steckern (4, 4a), die durch die Pressung gegen die Gehäuseteile (1, 1a) oder durch Anstecken oder Abziehen des Kupplungsteiles (9) auftreten, werden von den weiteren Fixiermitteln (7) aufgenommen.

In einem abschließenden Herstellungsschritt wird die Abdeckung (2) mittels der Scharniere (13) am Gehäuse befestigt.

Die Installation des elektrischen Gerätes kann z.B. wie folgend ablaufen:
Das Gehäuse wird z.B. mittels Schrauben am Einbauort, z.B. im Motorraum oder am Rahmen eines Fahrzeuges, montiert. Daraufhin wird das mit den elektrischen Anschlußkabeln (10) versehene Kupplungsstück (9) auf den Stecker (4) gesteckt. Schließlich wird die Abdeckung (2) geschlossen und mit einer Rastvorrichtung oder Schrauben arretiert. Hierbei umgeben die beiden Teile (5 und 12) der Fixiermittel die von einem Wellrohr umhüllten Anschlußkabel (10) formschlüssig.

## Patentansprüche

1. Abgedichtetes Gehäuse (1, 1a) für eine im Gehäuseinneren angeordnete elektrische Baugruppe (3) mit folgenden Merkmalen:
a) es ist wenigstens ein abgedichtetes erstes elektrisches Anschlusselement (4, 4a) an dem Gehäuse vorgesehen,
b) das erste Anschlusselement (4, 4a) ist mit der elektrischen Baugruppe (3) elektrisch verbunden,
c) das erste Anschlusselement (4, 4a) ist in einem sockelförmig abgestuften Teil des Gehäuses (1, 1a) so angeordnet, dass es zum Anschluss eines zweiten elektrischen Anschlusselementes (9) geeignet ist, das dem ersten Anschlusselement (4, 4a) als Gegenstück zugeordnet ist,
d) das zweite elektrische Anschlusselement (9) ist mit elektrischen Anschlusskabeln (10) versehen,
e) das Gehäuse (1, 1a) weist einen Bereich (11) auf, in dem die elektrischen Anschlusskabel (10) parallel zur flächigen Ausdehnung der Gehäuseoberfläche an der **Gehäuseoberfläche** angeordnet sind, **gekennzeichnet durch** folgende Merkmale:
f) es sind Fixiermittel (5, 5a) vorhanden zur Fixierung der elektrischen Anschlusskabel (10) am Gehäuse (1, 1a),
g) die Fixiermittel (5, 5a) bewirken eine Fixierung der Anschlusskabel (10) **an** der **Gehäuseoberfläche** in dem Bereich (11) des Gehäuses, in dem die Anschlusskabel (10) parallel zur flächigen Ausdehnung der Gehäuseoberfläche angeordnet sind,
h) wenigstens ein Teil der Fixiermittel (5, 5a) ist einstückig mit dem Gehäuse (1, 1a) ausgeführt.

2. Gehäuse nach Patentanspruch 1, **dadurch gekennzeichnet, dass** das Gehäuse (1, 1a) so ausgebildet ist, dass mindestens eine Abdeckung (2) für das erste (4, 4a) und zweite (9) elektrische Anschlusselement angebracht werden kann.

3. Gehäuse nach Patentanspruch 2 mit einer Abdeckung (2) für das erste (4, 4a) und zweite (9) elektrische Anschlusselement, **gekennzeichnet durch** die folgenden Merkmale:
a) die Fixiermittel bestehen aus einem ersten (5, 5a) und einem zweiten (12) Teil,
b) das erste Teil (5, 5a) der Fixiermittel ist so ausgebildet, dass es mit dem zweiten Teil (12) der Fixiermittel zur Anlage kommen kann,
c) das zweite Teil (12) der Fixiermittel ist einstückig mit der Abdeckung (2) ausgeführt.

4. Gehäuse nach einem der vorhergehenden Patentansprüche, **dadurch gekennzeichnet, dass** die Fixiermittel (5, 5a und 12) so ausgebildet sind, dass diese die elektrischen Anschlusskabel (10) oder eine diese umgebende Hülle formschlüssig aufnehmen können.

5. Gehäuse nach einem der vorhergehenden Patentansprüche 2 bis 4, **dadurch gekennzeichnet, dass** Befestigungselemente (13) vorgesehen sind, die zur Befestigung der Abdeckung (2) am Gehäuse (1, 1a) geeignet sind.

6. Gehäuse nach wenigstens einem der vorhergehenden Patentansprüche, **dadurch gekennzeichnet, dass** die Fixiermittel (5, 5a und 12) die Fixierung der Anschlusskabel (10) allein durch das Schliessen der Abdeckung (2) bewirken.

7. Gehäuse nach wenigstens einem der vorhergehenden Patentansprüche, **dadurch gekennzeichnet, dass** das Gehäuse (1, 1a) aus Metall und die Abdeckung (2) aus Kunststoff gefertigt ist.

8. Gehäuse nach wenigstens einem der vorhergehenden Patentansprüche, **dadurch gekennzeichnet, dass** das erste elektrische Anschlusselement (4, 4a) als abgewinkelter Stecker ausgebildet ist.

9. Gehäuse nach wenigstens einem der vorhergehenden Patentansprüche, **gekennzeichnet durch** die folgenden Merkmale:
a) das Gehäuse (1, 1a) ist zur Aufnahme einer elektrischen Baugruppe (3) geeignet,
b) die elektrische Baugruppe (3) ist so ausgebildet, dass sie mit dem ersten elektrischen Anschlusselement (4, 4a) verbunden werden kann,
c) die elektrische Baugruppe (3) und das erste elektrische Anschlusselement (4, 4a) sind geeignet zur Aufnahme von weiteren Fixiermitteln (7) zur Fixierung der Verbindung zwischen elektrischer Baugruppe (3) und erstem elektrischen Anschlusselement (4, 4a).

10. Gehäuse nach wenigstens einem der vorhergehenden Patentansprüche, das aus mehreren durch eine Teilungsebene voneinander getrennten Teilen (1, 1a) besteht, **dadurch gekennzeichnet, dass** zwischen der Teilungsebene der Gehäuseteile (1, 1a) und der elektrischen Baugruppe (3) ein rechter Winkel besteht.

11. Gehäuse nach wenigstens einem der vorhergehenden Patentansprüche, **dadurch gekennzeichnet, dass** es (1, 1a) geeignet ist für die Befestigung des ersten elektrischen Anschlusselementes (4, 4a) an der Gehäusewand allein durch die Montage der Gehäuseteile (1, 1a).

## Claims

1. Sealed housing (1, 1a) for an electrical module (3) arranged in the interior of the housing, having the following features:
a) at least one sealed first electrical connector element (4, 4a) is provided on the housing,
b) the first connector element (4, 4a) is electrically connected to the electrical module (3),
c) the first connector element (4, 4a) is arranged in a part, which is of stepped form in the manner of a pedestal, of the housing (1, 1a) so that said first connector element is suitable for connection of a second electrical connector element (9), which is associated with the first connector element (4, 4a) as counterpart thereto,
d) the second electrical connector element (9) is provided with electrical connecting cables (10),
e) the housing (1, 1a) has a region (11) in which the electrical connecting cables (10) are arranged on the housing surface parallel to the two-dimensional run of the housing surface, **characterised by** the following features:
f) fixing means (5, 5a) for fixing the electrical connecting cables (10) to the housing (1, 1a) are present,
g) the fixing means (5, 5a) effect fixing of the connecting cables (10) to the housing surface in the region (11) of the housing in which the connecting cables (10) are arranged parallel to the two-dimensional run of the housing surface,
h) at least part of the fixing means (5, 5a) is of integral construction with the housing (1, 1a).

2. Housing according to Patent Claim 1, **characterised in that** the housing (1, 1a) is constructed so that at least one cover (2) for the first (4, 4a) and second (9) electrical connector element can be mounted thereon.

3. Housing according to Patent Claim 2, having a cover (2) for the first (4, 4a) and second (9) electrical connector element, **characterised by** the following features:
a) the fixing means consist of a first (5, 5a) and a second (12) part,
b) the first part (5, 5a) of the fixing means is constructed so as to be engageable with the second part (12) of the fixing means,
c) the second part (12) of the fixing means is of integral construction with the cover (2).

4. Housing according to any one of the preceding patent claims, **characterised in that** the fixing means (5, 5a and 12) are constructed so that they are capable of receiving with a positive fit the electrical connecting cables (10) or a sheath surrounding these.

5. Housing according to any one of the preceding Patent Claims 2 to 4, **characterised in that** fastening elements (13) suitable for fastening the cover (2) to the housing (1, 1a) are provided.

6. Housing according to at least one of the preceding patent claims, **characterised in that** the fixing means (5, 5a and 12) effect fixing of the connecting cables (12) solely by closure of the cover (2).

7. Housing according to at least one of the preceding patent claims, **characterised in that** the housing (1, 1a) is made from metal and the cover (2) from plastics material.

8. Housing according to at least one of the preceding patent claims, **characterised in that** the first electrical connector element (4, 4a) is in the form of an angled plug connector.

9. Housing according to at least one of the preceding patent claims,
**characterised by** the following features:
a) the housing (1, 1a) is suitable for receiving an electrical module (3),
b) the electrical module (3) is constructed so that it can be connected to the first electrical connector element (4, 4a),
c) the electrical module (3) and the first electrical connector element (4, 4a) are suitable for receiving further fixing means (7) for fixing the connection between electrical module (3) and first electrical connector element (4, 4a).

10. Housing according to at least one of the preceding patent claims that consists of a plurality of parts (1, 1a) separated from one another by a dividing plane, **characterised in that** there is a right angle between the dividing plane of the housing parts (1, 1a) and the electrical module (3).

11. Housing according to at least one of the preceding patent claims, **characterised in that** it (1, 1a) is suitable for fixing the first electrical connector element (4, 4a) to the housing wall solely by assembly of the housing parts (1, 1a).

## Revendications

1. Boîtier (1, 1a) pour un module électrique (3) disposé à l'intérieur du boîtier, présentant les caractéristiques suivantes :
a) il est prévu au moins un premier élément de raccordement électrique étanchéifié (4, 4a) au niveau du boîtier,
b) le premier élément de raccordement (4, 4a) est relié électriquement au module électrique (3),
c) le premier élément de raccordement (4,4a) est disposé de telle sorte dans une partie étagée en forme de socle du boîtier (1, 1a) qu'il convient pour le raccordement d'un second élément de raccordement électrique (9), qui est associé en tant qu'élément antagoniste au premier élément de raccordement (4, 4a),
d) le second élément de raccordement électrique (9) est équipé de câbles de raccordement électriques (10),
e) le boîtier (1, 1a) comporte une zone (11), dans laquelle les câbles de raccordement électriques (10) sont disposés parallèlement à l'étendue plane de la surface du boîtier au niveau de la surface du boîtier, **caractérisé par** les caractéristiques suivantes :
f) des moyens de fixation (5,5a) sont prévus pour la fixation des câbles de raccordement électriques (10) au boîtier (1, 1a),
g) les moyens de fixation (5, 5a) réalisent une fixation des câbles de raccordement (10) au niveau de la surface du boîtier dans la zone (11) du boîtier, dans laquelle les câbles de raccordement (10) sont disposés parallèlement à l'étendue plane de la surface du boîtier,
h) au moins une partie des moyens de fixation (5,5a) est réalisée d'un seul tenant avec le boîtier (1, 1a).

2. Boîtier selon la revendication 1, **caractérisé en ce que** le boîtier (1, 1a) est agencé de telle sorte qu'au moins un capot (2) peut être monté pour le premier élément de raccordement électrique (4,4a) et pour le second élément de raccordement électrique (9).

3. Boîtier selon la revendication 2, comportant un capot (2) pour le premier élément de raccordement électrique (4, 4a) et pour le second élément de raccordement électrique (9),
**caractérisé par** les caractéristiques suivantes :
a) les moyens de fixation sont constitués par une première partie (5, 5a) et une deuxième partie (12),
b) la première partie (5, 5a) des moyens de fixation est agencée de telle sorte qu'elle peut venir s'appliquer contre la deuxième partie (12) des moyens de fixation,
c) la deuxième partie (12) des moyens de fixation est réalisée d'un seul tenant avec le capot (2).

4. Boîtier selon l'une des revendications précédentes, **caractérisé en ce que** les moyens de fixation (5, 5a et 12) sont agencés de telle sorte qu'ils peuvent loger, selon une liaison par formes complémentaires, les câbles de raccordement électriques (10) ou une enveloppe entourant ces câbles.

5. Boîtier selon l'une des revendications précédentes 2 à 4, **caractérisé en ce qu**'il est prévu des éléments de fixation (13), qui conviennent pour fixer le capot (2) au boîtier (1, 1a).

6. Boîtier selon au moins l'une des revendications précédentes, **caractérisé en ce que** les moyens de fixation (5,5a et 12) réalisent la fixation des câbles de raccordement (10) uniquement sous l'effet de la fermeture du capot (2).

7. Boîtier selon au moins l'une des revendications précédentes, **caractérisé en ce que** le boîtier (1, 1a) est formé d'un métal et le capot (2) est réalisé en une matière plastique.

8. Boîtier selon au moins l'une des revendications précédentes, **caractérisé en ce que** le premier élément de raccordement électrique (4, 4a) est agencé sous la forme d'un connecteur coudé.

9. Boîtier selon au moins l'une des revendications précédentes,
**caractérisé par** les caractéristiques suivantes :
a) le boîtier (1, 1a) convient pour loger un module électrique (3),
b) le module électrique (3) est agencé de telle sorte qu'il peut être relié au premier élément de raccordement électrique (4, 4a),
c) le module électrique (3) et le premier élément de raccordement électrique (4, 4a) sont appropriés pour loger d'autres moyens de fixation (7) pour fixer la liaison entre le module électrique (3) et le premier élément de raccordement électrique (4, 4a).

10. Boîtier selon au moins l'une des revendications précédentes, qui est constitué par plusieurs parties (1, 1a) séparées les unes des. autres par un plan de séparation, **caractérisé en ce que** le plan de division des parties (1, 1a) du boîtier et le plan des divisions du module électrique (3) font entre eux un angle droit.

11. Boîtier selon au moins l'une des revendications précédentes, **caractérisé en ce qu**'il (1, 1a) convient pour la fixation du premier élément de raccordement électrique (4, 4a) à la paroi du boîtier uniquement au moyen du montage des parties (1, 1a) du boîtier.
